# EUROPEAN PATENT SPECIFICATION

(11) **EP 2 267 818 B1**
(45) Date of publication and mention of the grant of the patent: **22.03.2017**
(21) Application number: 09008168.8
(22) Date of filing: 22.06.2009
(51) Int. Cl.: H01L 51/52

(54) **Organic lighting device**
Organische Beleuchtungsvorrichtung
Dispositif d'éclairage organique

(43) Date of publication of application: 29.12.2010
(73) Proprietor: Novaled GmbH, 01307 Dresden (DE)
(72) Inventor: Birnstock, Jan, 01187 Dresden (DE); Murano, Sven, 01324 Dresden (DE)
(74) Representative: Bittner, Thomas L.

(56) References cited:
- EP-A- 1 503 469
- US-A1- 2005 140 277
- US-A1- 2006 232 199
- US-A1- 2009 066 237
- US-A1- 2009 153 036

## Description

The invention relates to an organic lighting device, in particular an organic light-emitting diode (OLED).

### Background of the invention

Organic lighting devices also referred to as organic light emitting components in the form of organic light-emitting diodes (OLEDs) which emit coloured light, in particular white light, have received increased attention in recent years. It is generally known that the technology of organic lighting components has a great potential for possible applications in the field of lighting technology. In the meantime, organic light-emitting diodes have attained output efficiencies in the range of conventional compact fluorescent lamps.

Organic light-emitting diodes are usually produced by means of a layered structure which is provided on a substrate. An organic layer system is situated in the layered structure between a bottom electrode (near the substrate) and a top electrode (distant from the substrate), so that the organic layer system can be acted on by an electrical voltage via the bottom electrode and top electrode. The organic layer system is produced from organic materials, and includes a light-emitting region. Charge carriers, namely, electrons and holes, recombine in the light-emitting region, and are injected into the organic layer system when an electrical voltage is applied to the bottom electrode and top electrode, and at that location are transported to the light-emitting region.

At least one of the electrodes is transparent, typically a transparent conductive oxide (TCO). Common TCOs are Indium Tin Oxide (ITO), Fluor Tin Oxide (FTO), Aluminium Zinc Oxide (AZO), Antimony Tin Oxide (ATO). The most employed TCO's are ITO (here, the concentration of In is usually greater than Sn), doped and non-doped tin oxides, and also zinc oxides.

A significant increase in light production efficiency has been achieved by integrating electrically doped layers into the organic layer system.

The organic lighting components may be used in various fields of application to generate light of any given colour.

The organic lighting components may be designed in such a way that they emit white light. Such components have the potential for providing a meaningful alternative to the lighting technologies which currently dominate the market, such as incandescent lamps, halogen lamps, low-voltage fluorescent lamps, or the like.

However, significant technical problems must still be solved for a successful commercialization of the technology for organic lighting components. A particular challenge is the use of OLED components to generate large quantities of light necessary for general lighting applications. The quantity of light emitted by an OLED component is determined by two factors: the brightness in the region of the luminous surface of the component, and the size of the luminous surface. The brightness of an organic lighting component cannot be arbitrarily increased. In addition, the service life of organic components is greatly influenced by the brightness. If, for example, the brightness of an OLED component is doubled, its service life is reduced by a factor of two to four. "Service life" is defined as the elapsed time for the brightness of the OLED component to drop to one-half of its original brightness during operation at a constant current.

The luminous surface of an OLED component for lighting applications must be selected according to a desired quantity of emitted light. A luminous surface in the range of several square centimeters to greater than one square meter is sought.

OLED components are typically operated as an electrical component at low voltage in the range of approximately 2 V to approximately 20 V. The current flowing through the OLED component is determined by the luminous surface. For a relatively small luminous surface of the OLED component of approximately 100 cm², a current of 1 A would be necessary at an assumed current efficiency of 50 cd/A and an application brightness of 5000 cd/m².

Large area OLEDs suffer from an increased tendency to form fatal short cuts between anode and cathode. One possible explanation for this observation could be that the higher total currents running through the device enable a quicker degradation along microscopic defects in the OLED layer structure, so-called preferred current paths. Due to the higher total device current going along with an increased device active area, shorts are formed more quickly and the device lifetime and the production yield are reduced.

Several approaches have been used to improve the short protection in large area OLEDs. For instance, the document US 2006/226522 describes a hybrid series-parallel connection scheme of OLEDs in an OLED panel; with the occurrence of an electrical short, only the defective OLED will fail without compromising the others. Still, the failure of a substantial large OLED affects the visual perception of the panel.

In EP 1 933 400, there is described a special electrode geometry which is self current limiting. Once a short occurs, only a thin stripe will fail and the large area OLED will keep working with minimal loss in illumination and power efficiency. The solution provided by EP 1 933 400 is a considerable advance compared to US 2006/226522; however both techniques require complex electrode patterning, they reduce but do not completely solve the problem of a defective area which compromises the visual effect of a large area OLED.

There is a general need for a simple and efficient short circuit protection structure in large area OLEDs.

The document US 2009/153036 A1 relates to an organic device.

The document US 2006/232199 A1 relates to an organic electroluminescent display device.

The document US 2009/066237 A1 describes an organic electroluminescent device.

The document EP 1 503 469 A relates to a laser emitting apparatus.

The document US 2005/140277 A1 describes a display device having a plurality of pixels.

### Summary of the invention

It is the objective of the invention to provide an organic light emitting device with improved protection against short circuit. It is another objective to provide a large area lighting device, preferably a white light emitting device.

An organic light emitting device according to independent claim 1 and a lighting device according to independent claim 10 are provided.

The invention provides the advantage that an improved short circuit protection is established which also leads to a higher production yield. An additional advantage of the invention is the higher luminance homogeneity of the device. In addition, there is a longer lifetime of the organic lighting device. The top electrode is provided with a reduced lateral conductivity, thereby limiting the electrical current which could flow through a defect in the organic light emitting device which prevents the formation of a fatal short-cut.

However, (semi)transparent electrodes have also only a limited capability to transport currents without ohmic losses and therefore the homogeneity and the power efficiency of the devices are reduced.

According to a preferred embodiment, a top contact consisting of an electrode layer with a low conductivity is used, like ITO or a thin metal layer, the electrode layer functioning as a short reduction layer. A second, highly reflective thick metal electrode is provided on top of the short reduction layer. This second electrode is used to have the mirror function required in many applications. To enhance the short reduction functionality, an isolating layer is provided between the first (short reduction) electrode layer and the second (reflective) layer. There are some regions in which a direct contact between the reflective metal layer and the short reduction layer is established, which allows for a current distribution via the highly conductive reflective electrode to avoid inhomogenities and efficiency losses.

In a preferred embodiment of the invention, the electrical conductive layer is provided with an electrical sheet resistance in the range of about 1 Ω/square to about 50 Ω/square.

The reflective layer is separated from the electrical conductive layer by a closed electrical non-conductive layer. The electrical non-conductive layer is provided as closed layer at least in an active area which is an overlapping region between the bottom electrode and the electrical conductive layer when looking at the light emitting device from the bottom.

The electrical conductive layer is electrically connected to the reflective layer.

Electrical connection between the electrical conductive layer and the reflective layer is provided via open regions of the electrical non-conductive layer. In open regions provided in the active area there is no electrical non-conductive layer coverage, therefore, the electrical non-conductive layer is not closed in such open regions. In the open regions provided in the active area the electrical connection may be provided by direct contact between the electrical conductive layer and the reflective layer. As an alternative, the open regions preferably provided in the active area may be provided as filled areas filled partially or totally with an electrically conductive material which is in contact with both the electrical conductive layer and the reflective layer thereby establishing the electrical connection between such two layers. Such filled areas may also be preferred to vias. Also a combination of direct contact areas between the electrical conductive layer and the reflective layer and filled areas may be provided in another embodiment.

In a preferred embodiment, the open regions provide less than 5% of the total area of the active area. In conclusion, at least about 95% of the active area is covered by the electrical non-conductive layer.

In still a further preferred embodiment of the invention, the electrical non-conductive layer is made of an inorganic material.

In yet another embodiment of the invention, the refractive index of the electrical non-conductive layer is between 1.6 and 2.1.

In a preferred embodiment, the reflective layer is provided with a reflectance in the visible range of wavelengths which is at least 75 %.

In still another preferred embodiment, the electrical non-conductive layer is provided with a layer thickness in the range of 400 nm to 10 µm. In a further embodiment of the invention, the electrical non-conductive layer is provided with a layer thickness in the range of 30 nm to 100 nm.

In still another preferred embodiment, at least about 95% of an active area is covered by the electrical non-conductive layer.

The encapsulation may comprise a thin film encapsulation. The encapsulation may comprise a lid. Preferably, the lid is made of glass or metal.

### Description of preferred embodiments of the invention

Following the invention will be described in further detail, by way of example, with reference to different embodiments. In the figures,
- Fig. 1: shows a schematic representation of a layer structure of an organic light emitting device,
- Fig. 2: shows a schematic representation of layers composing a top electrode,
- Fig. 3a: shows a schematic representation of a layer structure of an organic light emitting device wherein connections are provided and an encapsulation is not in direct contact to a top electrode,
- Fig. 3b: shows a schematic representation of a layer structure of an organic light emitting device wherein connections are provided and an encapsulation is in direct contact to a top electrode, and
- Fig. 4: shows an electrical contact point distributed on a surface of an organic light emitting device.

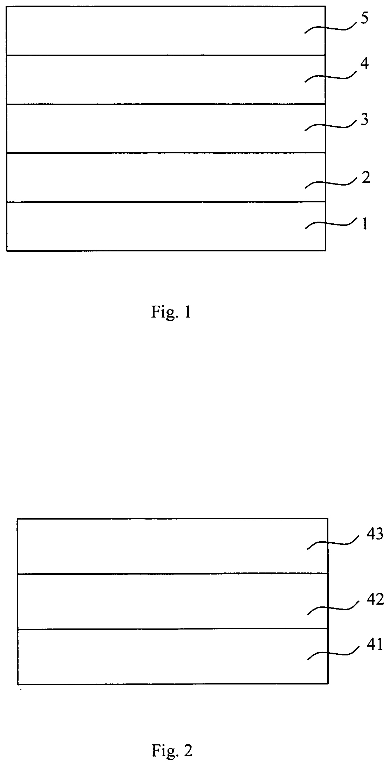

Referring to Fig. 1, a schematic representation of a layer structure of an organic light emitting device is shown. The layer structure comprises a substrate 1 provided as a transparent layer, a bottom electrode 2 also provided as a transparent layer, where one side of the bottom electrode 2 is facing the substrate 1, a top electrode 4, and a light emitting layer region 3 between the bottom electrode 2 and the top electrode 4. The light emitting region 3 can be provided as a single layer or a multilayer region comprising more than one layer. One surface of an encapsulation 5 is facing the top electrode 4, and the other surface of the encapsulation 5 is facing away from the substrate 1.

In general, the bottom electrode 2 is the electrode situated in between the substrate 1 and the light emitting layer region 3. The top electrode 4 is the electrode which is not situated in between the substrate 1 and the light emitting layer region 3.

The organic light emitting device shown in Fig. 1 is a so called bottom emitting device, where the light generated in the light emitting region 3 is emitted through the substrate 1. In a preferred embodiment the organic light emitting device may be provided as an organic light emitting device also referred to as OLED. In a preferred embodiment, the light emitting region 3 comprises an organic light emitting layer.

The substrate 1 is a transparent substrate, e.g. made of glass or plastic. The optical transmittance of the substrate is preferentially greater than or at least 80 %, more preferentially greater than or at least 90 %, even more preferentially greater than or at least 98 %. Other requirements for the substrate 1 are the same as for conventional bottom emitting OLEDs. This transmittance values are typical values of glass and plastic substrates. In some embodiments the substrate may be a multiple layer structure (such as a moisture barrier) with decreased optical transmittance; such transmittance should not be lower than 80 %, otherwise the efficiency of the device would be compromised.

The bottom electrode 2 comprises a transparent conducting layer preferentially made of a transparent conductive oxide. The thickness of the transparent conducting layer is 10 to 300 nm (the limits are included), preferentially 40 to 150 nm (the limits are included). 10 nm provides a lower limit for a closed layer configuration, meaning that there is a closed surface provided. 300 nm provides a maximum layer thickness that still allows for an appropriate transparency of the TCO above approx. 70%. 150 nm is a typical thickness for OLED grade ITO. This number is a compromise of maximum transparency and minimum resistivity.

The transparent conducting layer may also be provided as a very thin metal layer. The thin metal layer can be a single metal, e.g. Ag, Au, Al; the thin metal layer can also be a mixture, or an alloy of metals, such as Ag:Mg, Mg:Ag:Ti and others. The thin metal layer has a thickness in the range of 8 to 50 nm, preferentially 10 to 20 nm (the limits are included). The thickness of the thin metal layer will depend on the used metal; typically a smooth metal layer as thick as 5 nm is an almost closed layer, which has enough percolation paths to carry an electrical current. A metal layer thicker than 20 nm tends to be reflective (i.e., not enough transparent), for some metals, and/or mixtures (or alloys) it is possible to form transparent layers as thick as 50 nm.

Optionally, the bottom electrode 2 may be provided as a stack of alternating transparent conductive oxide and metal layers; which stack comprises at least two alternated layers. This kind of stack is also known as IMI stack (IMI - alternating transparent conductive oxide and metal layers). Preferentially the stack comprises the layer sequence TCO-Metal-TCO. An example of such a stack is ITO-Metal-ITO. Any metal can be used in such a stack; a preferred metal is Ag because of its high conductivity and comparably low absorption.

The bottom electrode 2 has a limited conductivity defined by a sheet resistance between 1 Ω/square (ohms / square) and 50 Ω/square (the limits are included); preferentially the sheet resistance of the bottom electrode 2 is between 1 Ω/square and 20 Ω/square (the limits are included). A sheet resistance of 1 Ω/square is the lower limit that can typically be achieved with an IMI or a thin metal electrode. 20 Ω/square is approx. the lowest resistivity that can be achieved with an ITO layer that has an appropriate transparency well above 70%. For ITO layers that are not thermally treated (thermal annealing), the limit is rather in the range of 50 Ω/square.

The bottom electrode 2 could further comprise a supporting metal mesh or grid. The conductivity of the bottom contact shall be defined without this mesh or grid.

The bottom electrode 2 is transparent with an optical transmittance for the emitted light greater than or at least 70 %, preferentially greater than or at least 85 %. 70% is a typical value for an IMI stack suited for OLEDs, 85% is a typical value for OLED grade ITO.

Preferably, the refractive index, in the visible range of wavelengths, of the layer(s) in the bottom electrode 2 is in between 1.6 to 2.1 (the limits are included). Preferably, the refractive index is close to the refractive index of the organic layers, because this limits internal reflection. The refractive index of the organic layers is in the range between 1.7 and 1.8 (the limits included).

Provided in between the bottom electrode 2 and the top electrode 4 is the light emitting layer region 3. The light emitting layer region 3 comprises an organic semiconductor as its main component. The light emitting layer region 3 also comprises at least one material capable to emit light when the device is excited upon application of a voltage on the bottom electrode 2 and the top electrode 4; which material can be the main component in the layer and / or an emitter dopant.

Preferably, additional layers are provided in between the bottom electrode 2 and the top electrode 4. Such layers are typical layers used in OLEDs which can be categorized as follows: charge transport layers, charge blocking layers, exciton blocking layers, charge injection layers, emitter layers, buffer layers, spacer layers, internal outcoupling layers, exciton transport layers, and charge generation layers. Conventional layers as such used in an OLED are described, for example, in the documents US 2004/0062949, US 2006/250076, EP 1 806 795.

The invented OLED can also comprise more than one light emitting layer 3, for example in so called tandem, stacked, or also called cascade OLEDs. Examples of stacked OLEDs are described in EP 1 804 309, also in US 2009/001885.

In another advanced mode of the invention, the OLED comprises more than one light emitting layer 3 embedded in between the charge transport layers. Examples of such layers are described in the patent publications EP 1 705 727, US 2008/203406. In this embodiment the multiple layers in the light emitting zone can comprise different matrix materials and optionally different emitter dopants.

The light source may be a mixed color light source. The organic light emitting device may be provided in a white light emitting configuration.

Fig. 2 is a schematic representation of the layers composing the top electrode 4. In the depicted embodiment, the top electrode 4 consists of the following layer sequence: a low conductive layer 41 electrically conductive, a non-conductive layer 42 electrically non-conductive and formed over the low conductive layer 41, and a reflective layer 43 formed over the non-conductive layer 42.

Following the low conductive layer 41 is described in further detail.

The low conductive layer 41 is provided with a sheet resistance between 1 Ω/square (ohm/square) and 50 Ω/square (the limits are included). Preferentially the sheet resistance of the bottom electrode 2 is between 1 Ω/square and 20 Ω/square (the limits are included). Optionally the sheet resistance of the low conductive layer 41 is the same (with a tolerance of 10 %) as the sheet resistance of the bottom electrode 2. A resistance of 1 Ω/square is a lower limit that can typically be achieved with an IMI stack or with a thin metal electrode. 20 Ω/square is approx. the lowest resistivity that can be achieved with an ITO layer that has an appropriate transparency well above 70%. For ITO layers that are not thermally treated (thermal annealing), the limit is rather in the range of 50 Ω/square.

The top electrode may further comprise a supporting metal mesh or grid. The conductivity of the top contact shall be defined without this mesh or grid.

The bottom electrode 2 or also the low conductive layer 41 may comprise an electrically conductive nanotube, fullerene, or graphene layer.

The low conductive layer 41 comprises a transparent conducting layer which has the same requirements as the transparent conducting layer described above for the bottom electrode 2. The deposition of the low conductive layer 41 must be made in such a way that no significant effect or damage of the properties of the light emitting region 3 takes place. This restricted production flexibility usually leads to a low conductive layer 41 with different properties if compared to the transparent conductive oxide layer which can be used in the bottom electrode 2, e.g. thermal annealing is not always possible for the top contact. In a preferred embodiment of the invention, the sheet resistance of top and bottom electrode are similar. In case of the use of a mesh or a grid, this sheet resistance includes mesh or grid.

Preferentially, the low conductive layer 41 is a transparent conductive oxide (TCO) layer. Optionally, the low conductive layer 41 is a thin metal layer. In another embodiment, the low conductive layer 41 is a stack of alternating transparent conductive oxide and metal layers (IMI), as explained above.

The low conductive layer 41 must be transparent for light emitted by the device, with an optical transmittance greater than or at least 70 %, preferentially greater than or at least 85 %.

70% is a typical value for an IMI stack suited for OLEDs, 85% is a typical value for OLED grade ITO.

Preferentially, the low conductive layer 41 and the non-conductive layer 42 have a summed total optical transmittance, in the range of wavelengths of the light emitted by the device, greater than at least 70 %, more preferentially greater than 85 %.

More preferentially, the low conductive layer 41 and the non-conductive layer 42 have a combined spectral optical transmittance over the visible range of wavelengths, which is greater than or at least 75 %, for each wavelength.

Following the non-conductive layer 42 is described in further detail.

The non-conductive layer 42 has a spectral optical transmittance over the visible range of wavelengths, which is greater than or at least 75 %, for each wavelength.

The non-conductive layer 42 has the function to electrically isolate the low conductive layer 41 from the reflective layer 43. Therefore it has a conductivity which is lower than 10⁻¹⁰ S/cm. This means the conductivity has to be lower than the conductivity of an OLED transport material. Preferentially, the non-conductive layer 42 consists of an insulator and has a conductivity which is lower than 10⁻¹⁸ S/cm; this value is a typical conductivity for insulator layers. All electrical conductivities are defined as DC (direct current) conductivities.

Optionally the non-conductive layer 42 can be made of a conjugated material, provided it has a very low conductivity and low mobility. Typically, a layer which has a thickness greater than 70 nm made with a material with a charge carrier mobility lower than 10⁻⁶ cm²/(V.s) can be used as a non-conductive layer. This is not the preferred solution, but it may be very convenient, since such materials can be cheap and can be easily processed. Alternatively or in combination, the non-conductive layer 42 is composed by semiconductive oligomers, dendrimers, polymers, or co-polymers, which have a very high resistivity. Examples are polyfluorene, poly(fluorene-phenylene), poly-thiophene, poly- p-phenyl phenol, etc.

The thickness of the non-conductive layer 42 can be any in between 5 nm to 10 µm (10 micrometer), preferentially between 30 nm to 10 µm. 5 nm is the lower limit for an insulating closed layer, however some materials only form a close layers with a thickness larger greater than 25 nm. 10 µm is the maximum that can be applied via vacuum processes or via wet-chemical processes with a reasonable tact time below 15 minutes. Preferentially the thickness of the non-conductive layer 42 is either in the range of 5 to 100 nm (the limits are included), more preferentially in the range of 40 to 100 nm (the limits are included). Optionally the thickness of the non-conductive layer 42 is in the range of 400 nm to 10 µm (the limits are included). These ranges of thicknesses are preferred because it avoids the occurrence of optical effects, such as an alteration of the emitted colour of the device and angle dependent colour emission created by the micro cavity. The lower range (5 to 100 nm, preferably 40 to 100 nm) is preferred because in this thickness range, the layer thickness can be well controlled and thus unwanted optical cavity effects can be avoided. In the range above 400 nm to 10 µm, the variations in color and efficiency (also under different viewing angles) with varying layer thickness are less pronounced and therefore a homogeneous appearance of the OLED is given even under variations of layer thickness in a typical process range.

Preferentially, the refractive index is between 1.6 and 2.1. Ideally, the refractive index is close to the refractive index of the organic layers as explained above.

Preferentially non-conductive layer 42 is composed by organic materials.

The non-conductive layer 42 can be composed by organic materials, for example by an organic layer, which can be conjugated or non-conjugated.

Alternatively or in combination, the non-conductive layer 42 is composed by insulative monomers, oligomers, dendrimers, polymers, or co-polymers. Examples are acryl monomer, polyacrylate, polyethylene, polymethylmethacrylate, and polystyrene. In another embodiment the non-conductive layer 42 is composed of inorganic material. Examples of such inorganic materials are oxides, nitrides, selenides, or combinations thereof. In another embodiment the non-conductive layer is composed of one of the following compounds: A1203, BaO, MgO, HfO2, ZrO2, CaO2, SrO2, Y2O3, Si3N4, A1N, GaN, ZnS and CdS. Alternatively, the non-conductive layer 42 comprises organic and inorganic materials.

An electrical insulating polymer layer in non-conductive layer 42 can be deposited, for example, by spraying a liquid monomeric precursor on the substrate which posterior UV curing. The monomer units can be, but are not limited to: acrylamide compounds, styrene compound, maleic anhydride, (meth)acrylates, urethane-(meth)acrylates, polyester-(meth)acrylates, epoxy(meth)acrylates, α-methylstyrene, 4-methylstyrene, divinylbenzene, 4-hydroxystyrene, 4-carboxystyrene, etc.

The advantage of using organic materials in non-conductive layer 42 is that the same deposition processes can be used, which are also used to form the organic semiconductor layers. In this way, the non-conductive layer 42, the light emitting layer 3, and other layers can easily be produced with the same equipment. Also, the refractive index of organic layers usually fits to the refractive index of OLED materials. Layers of organic materials can also be easily deposited over other organic materials without damaging the underlying layers. On the contrary, in most cases the inorganic materials need to be deposited using high temperature or high energetic particles (by sputtering), and care must be taken to avoid damage to the underlying layers.

The advantage of using inorganic, instead of organic materials, in the non-conductive layer 42 is that these inorganic materials usually have higher electrical resistance; the inorganic materials also have higher mechanical resistance towards mechanical damaging, for example, by scratching. Another advantage of the inorganic over the organic materials is that they are cheaper and easily available.

Following, the reflective layer 43 is described in further detail.

The reflective layer 43 is a completely closed layer. The closed layer is necessary to make a device with highest efficiency.

The reflective layer 43 has a reflectance in the visible range of wavelengths, which is greater than or at least 75 %. Preferentially the reflective layer 43 has a reflectance greater than or at least 90 % in the whole visible range. It is also preferred that the reflective layer 43 has a spectral reflectance, which is greater than or at least 75 % for each wavelength in the visible range of wavelengths.

It is also preferred that the reflective layer 43 is opaque to visible and infra-red light. It is preferred that the reflective layer 43 has a spectral reflectance which is greater or at least 75 %, more preferably greater or at least 85 % for each wavelength in the range of wavelengths between at least 450 nm to 1150 nm, more preferable between at least 380 nm to 1150 nm (the limits are included). This extended range is preferred for many reasons: one reason is that the solar spectrum, which may be incident on the top side (opposite from the substrate) on outdoor applications (such as a street lamp), must be reflected to avoid undesired heating of the device.

It is more preferred that the reflective layer 43 consists of a metal layer, such as Aluminium, or Silver.

The thickness of the reflective layer 43 is in between 50 nm and 2 µm, preferably between 50 nm and 200 nm.

Optionally, the reflective layer 43 consists of a reflective but electrically not conductive single layer, such as a transparent matrix comprising reflective metal particles, which are electrical insulated from each other in such a way that there is no conductive percolation path trough the layer.

The word reflectance means the total optical reflectance in the given spectral range; in contrast to the spectral reflectance, which is resolved in the spectra, i.e., it is defined for each wavelength in the given spectral range. The visible range of wavelengths is defined as the range of wavelengths between 380 nm to 750 nm.

The reflective layer 43 must not be in direct contact with the layers comprised in between the bottom electrode 2 and the top electrode 4.

In a preferred mode of the invention the layers 41, 42, and 43 are deposited in a staggered way, such that layer 43 has a lower area than layer 42, and layer 42 has a lower area than layer 41; where one surface of layer 43 completely contacts layer 42 and one surface of layer 42 completely contacts layer 41.

In another mode of the invention, the layers 41, and 43 are deposited in a staggered way, such that layer 43 has a lower area than layer 41; where one surface of layer 43 completely contacts layer 42, and layer 42 is deposited beyond a border of layer 41.

The area of the reflective layer 43 covers at least the active area of the device, and is preferentially 10 % larger. The active area is defined as the area where the light is emitted, this area can be determined observing the substrate from the surface normal (surface normal is the geometric definition). It is preferred that the active area of the device is at least 100 mm² (100 square millimetre) or larger. It is preferred that one lateral dimension of the active area of the invented device is at least 10 mm. The relatively large area of the device is necessary to achieve the short protection effect in the invention.

The encapsulation 5 may be an encapsulation cover or an encapsulation layer. The encapsulation 5 provides a complete sealing of the device's active area. The encapsulation forms a barrier against moisture, gas, and contaminants, which should not reach the top electrode and the light emitting region in the active area of the device. The encapsulation is typically connected (by, e.g., gluing or frit welding) to the substrate 1. Electrical connections (not shown in the Fig. 1) are provided in between the substrate 1 and the encapsulation 5 to allow for external connection; these connections may be extensions of the top electrode 4, extension of the bottom electrode 2, extension of the low conductive layer 41, or additional electrical conduction layers. One can easily think about many different possibilities to provide the electrical connections. It may happen that, for practical reasons it cannot be avoided that the extensions of other layers of the device are placed between the substrate 1 and the encapsulation 5; in such a case at least the active area of the device must be contained in the encapsulation volume.

In a preferred embodiment, there is more than one single OLED connected in series or in parallel, or in series and parallel; which OLEDs are all enclosed by the same encapsulation 5.

In another preferred embodiment, the low conductive layer 41 does not completely cover the layers comprised between the bottom electrode 2 and the top electrode 4, to avoid electrical short between the top electrode and the bottom electrode.

The encapsulation can be a cover lid; examples of such encapsulations are described in US 2005/24827 and US 2005/227114. The encapsulation can be a thin film encapsulation; examples of such are described in US 2007/020451, US 2004/229051, and US 2001/015620. Preferentially the encapsulation comprises a getter which absorbs moisture and oxygen. Examples of such getters are described in US 2005/238803.

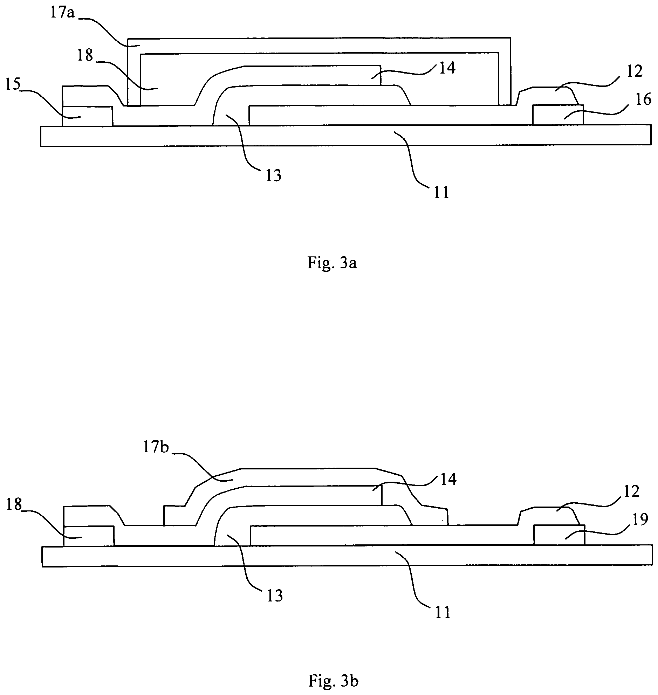

Fig. 3a and Fig 3b show a cross section view of one of the possible embodiments of the invented device.

A bottom electrode 12 partially covers the substrate 11. An electric wiring contact 16 is in direct electrical contact to the bottom electrode 12; this electrical contact can be formed by at least partially forming the electric wiring contact 16 over the bottom electrode 12. Optionally, the electrical contact can be formed by at least partially forming the bottom electrode 12 over the electric wiring contact 16.

The at least one light emitting layer 13 is formed partially covering the bottom electrode 12. The at least one light emitting layer 13 can optionally be deposited over a border of the bottom electrode 12; an additional insulator layer (not shown) can also be used to define the contact area between the at least one light emitting layer 13 and the bottom electrode 12. Optionally, layer 13 comprises a stack of organic layers, organic or inorganic injection layer or other layers.

The top electrode 14 is formed at least partially overlapping the stack of organic layers 13. The top electrode 14 extends out of the active area. On the extension, out of the active area, the top electrode 14 is in electrical contact to an electric wiring contact 15. The electrical contact can be formed by at least partially forming the top electrode 14 over the electric wiring contact 15.

The top electrode 14 may not be in contact with the bottom electrode 12.

At least a partial overlap is provided between the electric wiring contact 15 and the low conductive layer (which layer is not shown here for simplicity reasons, see Fig. 2, layer 41); this overlap is formed on the electric wiring contact 15 away from the substrate 11; optionally the overlap is formed between the substrate 11 and the electric wiring contact 15.

The device is encapsulated by an encapsulation cover 17a or by an encapsulation layer 17b. Fig. 3a shows an encapsulation cover 17a which is a moisture barrier. The encapsulation cover 17a is fixed to the substrate 1. The volume between the encapsulation cover 17a and substrate 1 (volume of layers 11-15 is not relevant in this case) is preferentially filled by an inert gas. The volume inside the encapsulated device optionally contains a getter material.

Following, a further embodiment of the organic light emitting device is described.

The device may be a very large area device; the reflective layer 43 is used as a conductor to supply electrical current to distant points of the low conductive layer 41. In this mode of the invention, the active area of the invented device is at least 4 cm² (square centimetres) or larger. Preferably the device has an active area of at least 25 cm². It is preferred that one lateral dimension of the active area of the invented device is at least 2 cm, more preferably at least 5 cm.

It is preferred that not more than one lateral dimensions of each device should be longer than 60 cm. The voltage drop in the device would lead to significant power losses if the electrode is too large.

The reflective layer 43 is in electrical contact to the low conductive layer 41. The electrical contact can be provided by interruptions in the non-conductive layer 42, thereby providing direct contact areas between the reflective layer 43 and the low conductive layer 41. The electrical contact may also be established by providing electrically conducting vias. The electrical contact points between the reflective layer 43 and the low conductive layer 41 are called ECPs. The number of ECPs is limited. They are localized in such a way to not compromise the short protection effect; which effect is at least partially provided by the low conductive layer 41.

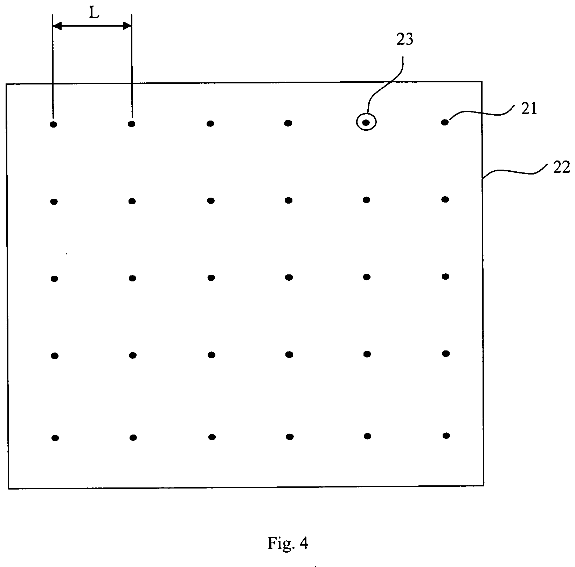

Fig. 4 shows the ECP 21 distributed on the surface of the device which has an active area defined by the outline 22. The region 23 immediately near an ECP does not offer a strong short protection because the ECP is conductive and does not limit a higher current to pass trough it. Figure 4 is a drawing showing one possible geometric distribution of the ECP on the active area; Fig. 4 does not show the visual impression of the device. For instance the ECP are made of metal and therefore they are reflective and give the visual impression as being part of the reflective layer.

The smallest distance L between two neighbouring ECP must be large. The ECP are separated by a minimum distance between each other which is at least 5 mm, more preferably at least 10 mm; otherwise, the effect of the invention is not given anymore (no good short protection). Upper limit is 50 mm; otherwise the light emission is too inhomogeneous.

The area defined by the ECP can have any desired geometry, for example, it can be round, square, a cross, or other format. The area of the ECP must be low such that the total summed area of all the ECP are less than 5 %, preferably less than 1 % of the total active area of the device.

Preferentially, the area of each single ECP is in between 0.01 mm² and 3 mm² (the limits are included), more preferentially in between 0.01 mm² and 0.02 mm² (the limits are included). A larger area of a single ECP is not desired since it compromises the short circuit protection effect. ECP with an area lower than 0.02 mm² is not distinguishable by an average human eye at a distance of 2 m or greater.

Following, a further embodiment of the organic light emitting device is described.

Preferably, a metal grid is provided on the bottom electrode 2. The metal grid is below (between substrate 1 and bottom electrode 2) or above the bottom electrode 2 (not in between substrate 1 and bottom electrode 2). In case the metal grid is over the bottom electrode 2 then its surface is passivated such that it does not directly contact the organic semiconducting layers. The geometry of the grid is designed to minimize the absorption of the emitted light by the metal, and still significantly contribute to the current distribution in the bottom electrode 2. The lines of the grid have a width which is at least 10 times smaller than the smallest gap between two metal lines.

The device may be provided with very high light emission homogeneity across the active area of the device. In this advanced mode, electrical connections are provided to electrically contact the top electrode and the bottom electrode; where the electrical connections are on opposite sides of the device (an observer is looking at a perpendicular angle towards the substrate); and where the portions of the electrical connections which are in direct contact to the top electrode or bottom electrode are essentially parallel to each other (with an angular tolerance of 15 %). In this mode which is not part of the claimed invention, the low conductive layer 41 and the reflective layer 43 are fully electrically insulated. The homogeneity is given by the fact that when bottom electrode and the top electrode have similar resistivity, any given current path through the device sees the same effective resistance. For example, a current path goes along the bottom electrode over a distance D1, through stack of organic layers, which has a total thickness D3, and along the top electrode over a distance D2. The current is supplied by an electric wiring. In the active region of the organic light emitting device the current path has a total length d = D1 + D2 + D3, where D2 and D3 are any according to d = D2 + D3. The fact that the bottom electrode 2 and the low conductive layer 41 have similar surface resistivity (with a tolerance of 20%), implies that the total resistance of a current path D is almost constant, which effect leads to a very high homogeneity in current distribution and in light emission. In this mode there is also no metal grid on the bottom electrode 2, because the metal grid would drastically modify the conductivity of the bottom electrode 2 compromising the homogeneity.

A very large area device may have a grid in the bottom electrode and ECPs in the top electrode.

The organic light emitting device may be provided with at least one of the following features:
- the main component of the bottom electrode 2 is a transparent conductive oxide layer;
- a light emitting layer comprises an organic matrix material;
- the electrical conductive layer 41 formed as a closed layer comprises at least one layer with an optical transparency in the visible range of more than 70 %, wherein the at least one layer is one of a transparent conductive oxide provided with a layer thickness in the range of 40 nm to 300 nm and a thin metal layer provided with a layer thickness in the range of 8 nm to 50 nm (which means the limits are included);
- the electrical non-conductive layer 42 is an insulating layer with an optical transparency of at least 70 % and a layer thickness in the range of 30 nm to 10 µm;
- the electrical non-conductive layer 42 covers more than 95% of the electrical conductive layer 41 in the active area of the device; and
- the reflective layer 43 is formed as a closed layer with optical reflectance in the visible range above or at least 90 % and a layer thickness of at least 50 nm.

Following, further aspects of the invention are described by reference to experimental studies.

### Example 1 (not forming part of the invention)

An organic light emitting device was produced on a glass substrate coated with ITO. The ITO layer is about 90 nm thick and does not cover the whole substrate's surface.

The substrate is cleaned in an ultra-sonication bath with isopropanol and moved into a glovebox from where it is transferred into the vacuum chamber. The organic layers are deposited using conventional vacuum thermal evaporation (VTE).

The following layers are deposited, partially covering the ITO layer, on an area of about 2.2 cm x 2.2 cm in the sequence: 150 nm thick NPD layer p-doped with 4 mol% of 1,3,4,5,7,8-Hexafluoronaphtho-2,6-chinontetracyanomethane as hole transport layer; 10 nm thick NPD (N,N'-Bis(naphthalen-1-yl)-N,N'-bis(phenyl)-benzidine) layer as electron blocking layer; 20 nm thick Spiro-DPVBi (2,2,7,7-tetrakis(2,2-diphenylvinyl)spiro-9,9-bifluorene); 10 nm 2,4,7,9-tetraphenyl-1,10-phenanthroline; 25 nm 2,4,7,9 - tetraphenyl-1,10-phenanthroline n-doped with 8 mol% of Tetrakis (1,3,4,6,7,8-Hexahydro-2H-pyrimido[1,2-a] pyrimidinato)ditungsten (II); 20 nm thick NPD layer p-doped with 4 mol% of 1,3,4,5,7,8-Hexafluoronaphtho-2,6-chinontetracyanomethane; 10 nm TCTA (4,4',4"-Tris(carbazol-9-yl)-triphenylamine) doped with 8mol% of the emitter dopant Irppy; 15 nm TPBI (1,3,5-Tris (1-phenyl-1H-benzimidazol-2-yl)benzene)doped with 12mol% of the emitter dopant Irppy; 10 nm 2,4,7,9-tetraphenyl-1,10-phenanthroline; 35 nm 2,4,7,9-tetraphenyl-1,10- phenanthroline n-doped with 8 mol% of Tetrakis (1,3,4,6,7,8-Hexahydro-2H-pyrimido[1,2-a]pyrimidinato)ditungsten (II); 30 nm thick NPD layer p-doped with 4 mol% of 1,3,4,5,7,8-Hexafluoronaphtho-2,6-chinontetracyanomethane; 10 nm thick NPD; 20 nm NPD doped with 10mol% of Iridium (III) bis(2-methyldibenzo[f,h]quinoxaline) (acetylacetonate); 10 nm 2,4,7,9-tetraphenyl-1,10-phenanthroline; 70 nm of 2,4,7,9-tetraphenyl-1,10- phenanthroline n-doped with 30 mol% of Tetrakis (1,3,4,6,7,8-Hexahydro-2H-pyrimido [1,2-a]pyrimidinato)ditungsten (II).

The sample was transferred to another chamber for ITO sputtering. A second ITO layer with a thickness of 80 nm was deposited by argon sputtering. The ITO layer area was defined with a shadow mask, to approximately 2.0 cm x 2.0 cm covering the organic layers; the ITO layer also has an extension on one side, which extension provides an electrical contact area. Aluminum oxide was deposited in the same chamber but with a higher partial oxygen pressure, to ensure a stoichiometric composition of the Aluminum oxide. The final layer thickness was 40 nm. The area was approximately 2.2 cm x 2.2 cm, aligned with the organic layers.

The sample was transferred to another chamber, for metal deposition, at a base pressure of 10⁻⁸ mbar. A 150 nm thick A1 layer was deposited by VTE. The A1 layer had an area of 2.0 cm x 2.0 cm, being aligned with the second ITO layer. Since this layer is deposited by VTE it can be well defined by a shadow mask.

Finally, individual glass encapsulation covers, containing a getter in the inner part (for moisture and oxygen) was glued on the substrate; completely encapsulating the active layers of the device in nitrogen atmosphere.

Twelve devices where made on the same substrate with 100% yield. The device show an efficiency of 60 cd/A at an operating voltage of 9 V and approximate CIE colour coordinates of x = 0.43; y = 0.45. After operating over 1000 h, at a current density of 10 mA/cm², all the OLEDs were still working.

### Example 2

A comparative sample was made, also with twelve devices, with the same layer structure and encapsulation as the example above; except that the top electrode (top ITO layer, Aluminium oxide layer, and top reflective layer) was substituted by a single Aluminium layer with a thickness of 150 nm. The yield was also 100%. After operating over 1000 h, at a current density of 10 mA/cm², 7 OLED were working. The other 5 OLEDs had a variable lifetime, experiencing sudden death during the aging test.

### Example 3 (not forming part of the invention)

A sample was made using a flexible PET (polyethylene terephthalate) substrate coated with ITO. The PET substrate has a thin film moisture barrier on the side which is not coated with ITO.

The organic layers and the top electrode were deposited as in example 1. A thin film encapsulation was deposited covering all the layers expect for the extensions of the electrical connections. The thin film encapsulation consists of a triple sequence of 250 nm of polymer and 50 nm of Aluminium oxide. The polymer is deposited by spraying a liquid precursor on the device and posterior UV curing. The Aluminium oxide is deposited by DC reactive sputtering.

The thin film encapsulation could also be employed in the example with a rigid substrate.

Twelve samples were made with a yield of 100 %. After operating for 3 days at a current density of 10 mA/cm² all devices were still working.

### Example 4

A comparative sample was made according to example 4, except that the top electrode (top ITO layer, Aluminium oxide layer, and top reflective layer) was substituted by a single Aluminium layer with a thickness of 150 nm.

Twelve samples were made with a yield of 83 %, only 10 devices worked. This is attributed to much the higher roughness of the ITO on PET substrate, easily leading to short circuits. After operating for 3 days at a current density of 10 mA/cm² only 8 devices were still working.

### Example 5

A very large area device with an active area of 15 cm x 15 cm was constructed according to the procedure in Example 1, except for the top electrode which was constructed according to the following:

An ITO layer with a thickness of 80 nm was deposited by argon sputtering. The ITO layer area was defined with a shadow mask, to approximately 15 cm x 15 cm covering the organic layers; the ITO layer also has an extension on one side of the device, which extension provides an electrical contact area.

The sample was transferred to another chamber, for the polymer deposition. The polymer is deposited by spraying a liquid precursor (for example methacrylate monomer) on the device and posterior UV curing. A shadow mask was used for the deposition of the insulating layer; which is essentially an open square containing 2 metal stripes spaced 5 cm apart and 5 cm of the border of the open square. Each metal stripe has a width of 1 mm. The polymer deposition was done in two steps: first 60 nm was deposited trough the shadow mask, in the second step, the shadow mask was rotated in-plane by 90° and another polymer layer of 60 nm was deposited. This method created 4 small regions which are not covered by the polymer and are used as ECPs.

The sample was transferred to another chamber, for metal deposition, at a base pressure of 10⁻⁸ mbar. A 150 nm thick A1 layer was deposited by VTE. The A1 layer was deposited over the whole active area and forming a closed layer and forming the four ECPs with the top ITO layer. The A1 layer had an extension to one side, overlapping and making electrical contact to the extension of the top ITO layer in a region which is not in the active area of the device. In this way the top A1 layer works, not only as a mirror layer, but also as a current supply for the top ITO layer. The device was encapsulated following the procedure as in example 1.

This very large area device showed light emission homogeneity comparable to the homogeneity of the much smaller device in example 1.

### Examples 6, 7, and 8 (not forming part of the invention)

Three device, with very large area with an active area of 15 cm x 15 cm and very high light emission homogeneity were produced,

The grid electrode was formed as a continuous layer deposited over an ITO layer. First a photoresist was patterned over the ITO by conventional photolithography in a negative picture of a grid. An aluminium layer with a thickness of 150 nm was deposited over the ITO with photoresist by VTE. The excess aluminium was removed with the photoresist by lift-off. The remaining metal grid has lines with a width of 450 µm and a spacing of 10 mm.

The substrate with ITO and aluminium grid was treated with oxygen plasma to create a thin aluminium oxide passivation.

### Example 6 (not forming part of the invention)

One of the 3 samples was finished as a conventional bottom emitting layer, having the layer structure and encapsulation as in example 2.

### Example 7 (not forming part of the invention)

One of the samples was finished according to Example 1.

### Example 8 (not forming part of the invention)

The third sample was finished according to example 4. The device of example 8 show a higher homogeneity than the device of example 7, however both show a very high homogeneity if compared to the device of example 6.

### Example 9 (not forming part of the invention)

New samples where produced following the procedure as in example 1 except that the reflective layer was deposited by spin coating a non-conductive metal ink. The spin coating was done in nitrogen atmosphere. After drying form 1h at 45 °C, the sample was encapsulated as in example 1.

The features disclosed in the claims may be material for the realization of the invention in its various embodiments, taken in isolation or in various combinations thereof.

## Claims

1. An organic light emitting device, the device comprising:
- a stack, comprising:
- a substrate (1),
- a bottom electrode (2),
- a top electrode (4),
- an organic region comprising a light emitting region (3), wherein the organic region is provided between the bottom (2) and the top electrode (4), and
- an encapsulation (5),
**characterized in that**
- the substrate (1) is transparent,
- the bottom electrode (2) is transparent,
- the top electrode (4) is provided with a layer structure comprising:
- an electrical conductive layer (41) provided as a transparent layer and electrically connected to the organic region,
- a reflective layer (43) formed as a closed layer over the light emitting region (3) and configured to reflect light generated in the light emitting region (3), and
- an electrical non-conductive layer (42) provided between the electrical conductive layer (41) and the reflective layer (43) as a transparent layer,
- electrical contact points are formed between the reflective layer (43) and the electrical conductive layer (41) such that the electrical conductive layer (41) is electrically connected to the reflective layer (43), wherein the electrical contact points are distributed on an active area of the organic light emitting device, wherein a minimum distance between the electrical contact points is at least 5 mm and a maximum distance between the electrical contact points is 50 mm.

2. Organic light emitting device according to claim 1, wherein the electrical conductive layer (41) is provided with an electrical sheet resistance in the range of 1 Ω/square to 50 Ω/square.

3. Organic light emitting device according to at least one of the preceding claims, wherein the electrical non-conductive layer (42) is made of an inorganic material.

4. Organic light emitting device according to at least one of the preceding claims, wherein the refractive index of the electrical non-conductive layer (42) is between 1.6 and 2.1

5. Organic light emitting device according to at least one of the preceding claims, wherein the reflective layer (43) is provided with a reflectance in the visible range of wavelengths which is at least 75 %.

6. Organic light emitting device according to at least one of the preceding claims, wherein the electrical non-conductive layer (42) is provided with a layer thickness in the range of 400 nm to 10 µm.

7. Organic light emitting device according to one of the claims 1 to 5, wherein the electrical non-conductive layer (42) is provided with a layer thickness in the range of 30 nm to 100 nm.

8. Organic light emitting device according to at least one of the preceding claims, wherein at least about 95% of an active area is covered by the electrical non-conductive layer (42).

9. Lighting device, comprising at least one organic light emitting device according to at least one of the preceding claims.

10. Lighting device according to claim 9, comprising a plurality of organic light emitting devices connected in series or in parallel, or in series and parallel, wherein the organic light emitting devices are encapsulated by the same encapsulation (5).

## Patentansprüche

1. Ein organisches lichtemittierendes Bauelement, aufweisend:
- einen Stapel, aufweisend:
- ein Substrat (1),
- eine untere Elektrode (2),
- eine obere Elektrode (4),
- einen organischen Bereich mit einem lichtemittierenden Bereich (3), wobei der organische Bereich zwischen der unteren (2) und der oberen Elektrode (4) gebildet ist, und
- eine Verkapselung (5),
**dadurch gekennzeichnet, dass**
- das Substrat (1) transparent ist,
- die untere Elektrode (2) transparent ist,
- die obere Elektrode (4) mit einer Schichtstruktur bereitgestellt ist, aufweisend:
- eine elektrisch leitende Schicht (41), die als transparente Schicht gebildet ist und elektrisch mit dem organischen Bereich verbunden ist,
- eine reflektierende Schicht (43), die als geschlossene Schicht über dem lichtemittierenden Bereich (3) gebildet ist und eingerichtet ist, das im lichtemittierenden Bereich (3) erzeugte Licht zu reflektieren, und
- eine elektrisch nichtleitende Schicht (42), die als transparente Schicht zwischen der elektrisch leitenden Schicht (41) und der reflektierenden Schicht (43) gebildet ist,
- elektrische Kontakte, die zwischen der reflektierenden Schicht (43) und der elektrisch leitenden Schicht (41) ausgebildet sind, so dass die elektrisch leitende Schicht (41) elektrisch mit der reflektierenden Schicht (43) verbunden ist, wobei die elektrischen Kontakte auf einem aktiven Bereich des organischen lichtemittierenden Bauelements verteilt sind, wobei zwischen den elektrischen Kontakten ein minimaler Abstand wenigstens 5 mm und ein maximaler Abstand 50 mm beträgt.

2. Organisches lichtemittierendes Bauelement nach Anspruch 1, wobei die elektrisch leitende Schicht (41) einen elektrischen Flächenwiderstand zwischen 1 Ω/□ und 50 Ω/□ aufweist.

3. Organisches lichtemittierendes Bauelement nach mindestens einem der vorhergehenden Ansprüche, wobei die elektrisch nichtleitende Schicht (42) aus einem anorganischen Material besteht.

4. Organisches lichtemittierendes Bauelement nach mindestens einem der vorhergehenden Ansprüche, wobei der Brechungsindex der elektrisch nichtleitenden Schicht (42) zwischen 1,6 und 2,1 beträgt.

5. Organisches lichtemittierendes Bauelement nach mindestens einem der vorhergehenden Ansprüche, wobei die reflektierende Schicht (43) einen Reflexionsgrad im sichtbaren Wellenlängenbereich von mindestens 75 % aufweist.

6. Organisches lichtemittierendes Bauelement nach mindestens einem der vorhergehenden Ansprüche, wobei die elektrisch nichtleitende Schicht (42) eine Schichtdicke zwischen 400 nm und 10 µm aufweist.

7. Organisches lichtemittierendes Bauelement nach einem der Ansprüche 1 bis 5, wobei die elektrisch nichtleitende Schicht (42) eine Schichtdicke zwischen 30 nm und 100 nm aufweist.

8. Organisches lichtemittierendes Bauelement nach mindestens einem der vorhergehenden Anspruche, wobei mindestens etwa 95 % eines aktiven Bereichs von der elektrisch nichtleitenden Schicht (42) bedeckt sind.

9. Beleuchtungseinrichtung mit wenigstens einem organischen lichtemittierenden Bauelement nach mindestens einem der vorhergehenden Ansprüche.

10. Beleuchtungseinrichtung nach Anspruch 9 mit mehreren organischen lichtemittierenden Bauelementen, die in Reihe, parallel oder sowohl in Reihe als auch parallel miteinander verschaltet sind, wobei die lichtemittierenden Bauelemente in derselben Verkapselung (5) verkapselt sind.

## Revendications

1. Dispositif électroluminescent organique, le dispositif comprenant :
- une pile comprenant :
- un substrat (1),
- une électrode inférieure (2),
- une électrode supérieure (4),
- une région organique comprenant une région électroluminescente (3), dans lequel la région organique est pourvue entre l'électrode inférieure (2) et l'électrode supérieure (4), et
- une encapsulation (5),
**caractérisé en ce que**
- le substrat (1) est transparent,
- l'électrode inférieure (2) est transparente,
- l'électrode supérieure (4) est pourvue d'une structure en couches comprenant :
- une couche électroconductrice (41) pourvue d'une couche transparente et connectée électriquement à la région organique,
- une couche réfléchissante (43) formée comme une couche fermée par-dessus la région électroluminescente (3) et configurée pour réfléchir la lumière générée dans la région électroluminescente (3), et
- une couche non électroconductrice (42) pourvue entre la couche électroconductrice (41) et la couche réfléchissante (43) comme une couche transparente,
- des points de contact électrique sont formés entre la couche réfléchissante (43) et la couche électroconductrice (41) de telle sorte que la couche électroconductrice (41) est connectée électriquement à la couche réfléchissante (43), dans lequel les points de contact électrique sont distribués sur une zone active du dispositif électroluminescent organique, dans lequel une distance minimale entre les points de contact électrique est d'au moins 5 mm et une distance maximale entre les points de contact électrique est de 50 mm.

2. Dispositif électroluminescent organique selon la revendication 1, dans lequel la couche électroconductrice (41) est pourvue d'une résistance électrique de couche mince dans la plage de Ω/carré à 50 Ω/carré.

3. Dispositif électroluminescent organique selon au moins l'une des revendications précédentes, dans lequel la couche non électroconductrice (42) est constituée d'un matériau inorganique.

4. Dispositif électroluminescent organique selon au moins l'une des revendications précédentes, dans lequel l'indice de réfraction de la couche non électro conductrice (42) est compris entre 1,6 et 2,1

5. Dispositif électroluminescent organique selon au moins l'une des revendications précédentes, dans lequel la couche réfléchissante (43) présente une réflectivité dans la plage visible des longueurs d'onde qui est d'au moins 75 %.

6. Dispositif électroluminescent organique selon au moins l'une des revendications précédentes, dans lequel la couche non électroconductrice (42) est pourvue d'une épaisseur de couche dans une plage de 400 nm à 10 µm.

7. Dispositif électroluminescent organique selon au moins l'une des revendications de 1 à 5, dans lequel la couche non électroconductrice (42) est pourvue d'une épaisseur de couche dans une plage de 30 nm à 100 nm.

8. Dispositif électroluminescent organique selon au moins l'une des revendications précédentes, dans lequel au moins environ 95 % d'une zone active est recouverte par la couche non électroconductrice (42).

9. Dispositif d'éclairage, comprenant au moins un dispositif électroluminescent organique selon au moins l'une des revendications précédentes.

10. Dispositif d'éclairage selon la revendication 9, comprenant une pluralité de dispositifs électroluminescents organiques connectés en série ou en parallèle, ou en série et en parallèle, dans lequel les dispositifs électroluminescents organiques sont encapsulés par la même encapsulation (5).
